# EUROPEAN PATENT APPLICATION

(11) **EP 4 478 420 A1**
(43) Date of publication of application: **18.12.2024**
(21) Application number: 23179248.2
(22) Date of filing: 14.06.2023
(51) Int. Cl.: H01L 29/40, H01L 29/417, H01L 29/78, H01L 29/66, H01L 29/10

(54) **SPLIT-GATE MOSFET**

(71) Applicant: Nexperia B.V., 6534 AB Nijmegen (NL)
(72) Inventor: KOH, Jie Qi, Manchester (GB); HAVALDAR, Dnyanesh, Manchester (GB); GHASEMI, Ali, Manchester (GB); GAJDA, Mark Andrzej, Manchester (GB)
(74) Representative: Pjanovic, Ilija

(57) **Abstract**

A semiconductor power device having an active region, the active region of the device comprising at least two split-gate trench regions, wherein the two laterally adjacent split-gate trench regions are separated by a mesa region, and two or more contact regions (115) of a first conductivity type located in the mesa region. The contact regions (115) of a first conductivity type are in contact with the two adjacent split-gate trench regions so that, in use, a channel is formed along a side of each split-gate trench region. The device further comprises at least two insulating spacer regions (160) located over and aligned with the two or more contact regions of a first conductivity type, and a source contact (155) extending from an upper surface of the device within the mesa region and between the at least two insulating spacer regions.

## Description

### Technical Field

The present disclosure relates to a power semiconductor device and a method of manufacturing a power semiconductor device, particularly but not exclusively, the present disclosure relates to a split-gate metal-oxide semiconductor field-effect transistor (MOSFET).

### Background

Trench metal-oxide-semiconductor field-effect transistors (MOSFETs), are widely known and used in many applications. In a trench MOSFET, current is conducted vertically from one surface of the MOSFET to the other surface of the MOSFET. Split-gate trench MOSFETs have improved performance and efficiency.

It is desired to produce MOSFET devices having a reduced cell pitch, for example having a cell pitch of less than 1.0 µm or less than 800nm, which increases reliance on lithography definition and alignment tolerance. In order to decrease cell pitch, other device dimensions may need to be reduced. Lithography, as well as contact-to-trench alignment, are limiting factors in achieving this reduced cell pitch and device dimensions.

Any misalignment of the source contact of a MOSFET, and thus deviation in the contact-to-trench distance, forces the implanted heavy-dose of p-type dopants (in some example, Boron) into the conduction channel on one side of the cell while depriving the other side of the cell of the p-type dopant. This leads to an imbalance of threshold voltage (V_{T}) between the two sides of the cell, which in turn has knock-on effects on both On-Resistance (R_{ON}) and ruggedness of the device.

US 6,924,198 B2 relates to a MOSFET having a contact that is not aligned. US 7,910,439 B2, US 8,951,867 B2, and US 9,735,266 B2 relate to MOSFETs without a split-gate structure.

### Summary

Aspects and preferred features are set out in the accompanying claims.

According to a first embodiment, there is provided a semiconductor power device having an active region, the active region of the device comprising:
a drift region of a first conductivity type;
a body region of a second conductivity disposed over the drift region, wherein the second conductivity type is opposite to the first conductivity type;
at least two split-gate trench regions in contact with the body region and the drift region, wherein two laterally adjacent split-gate trench regions are separated by a mesa region;
two or more contact regions of a first conductivity type located in the mesa region and disposed over the body region, wherein the contact regions of a first conductivity type have a higher doping concentration compared to the doping concentration of the drift region, and wherein the contact regions are in contact with the two adjacent split-gate trench regions so that, in use, a channel is formed along a side of each split-gate trench region and within the body region;
a contact region of a second conductivity type located in the mesa region and disposed over the body region, wherein the contact region of a second conductivity type has a higher doping concentration compared to the doping concentration of the body region, and wherein the contact region of a second conductivity type is in contact with the two or more contact regions of a first conductivity type within the mesa region;
at least two insulating spacer regions located over and aligned with the two or more contact regions of a first conductivity type;
a source contact extending from an upper surface of the device within the mesa region and between the at least two insulating spacer regions, wherein the source contact is in contact with the two or more contact regions of a first conductivity type and the contact region of a second conductivity type.

The split-gate trench regions improve the performance of the device. The insulating spacer regions act to align the contact regions of a first conductivity type and the source contact, within the mesa region. This improve reliability and reproducibility of the device.

The semiconductor device may further include at least two insulating plug regions located over the split-gate trench regions and adjacent to the dielectric spacer regions. The insulating plug regions allow for the insulating spacer regions to be formed in a simple and reproducible way by depositing an insulating layer and etching the insulating layer such that the etch process stops on the mesa region.

The insulating plug regions may be formed of the same material as the insulating spacer regions. The insulating plug regions and the insulating spacer regions may both comprise an oxide.

The insulating plug regions may be formed of a different material as the insulating spacer regions. The insulating plug region may comprise a nitride and the insulating spacer regions may comprise an oxide.

The semiconductor power device may be formed by:
forming the at least two split-gate trench regions within a semiconductor region, wherein two laterally adjacent split-gate trench regions are separated by a mesa region;
etching a gate conductive region within an upper region of each split-gate trench region;
forming the at least two insulating plug regions over the etched gate conductive regions, each insulating plug region being formed within a split-gate trench region; and
etching the semiconductor region within the mesa region between two adjacent split-gate trench regions.

Etching the semiconductor region within the mesa region leaves the insulating plug regions. The semiconductor region may be referred to as a semiconductor substrate. In some examples, the semiconductor region may comprise an initial substrate with further semiconductor layers epitaxially grown over the initial substrate.

The semiconductor power device may be formed by etching a recess within the body region of a second conductivity type in the mesa region. The etched recess may be defined by the insulating spacer regions. As the etched recess is defined by the spacer regions, the alignment of the etched recess is highly reliable.

The contact region of a second conductivity type may be formed by implanting a dopant of a second conductivity type into the body region of a second conductivity type below the etched recess. The implantation of the dopant is also highly reliable due to the reliability of the location of the etched recess.

The source contact may be formed by depositing a conductive material in the etched recess. The location of the source contact is also highly reliable due to the reliability of the location of the etched recess.

The split-gate trench regions may each comprise:
a gate conductive region formed in an upper portion of each split-gate trench region;
a source conductive region formed in a lower portion of each split-gate trench region; and
an insulation layer formed along sidewalls, a lower surface of each split-gate trench regions and between the gate conductive region and the source conductive region.

The semiconductor power device may further comprise an edge termination region. The edge termination region may be located laterally between the active region and a side surface of the semiconductor device.

The edge termination region may comprise a gate terminal having one or more split-gate trench regions.

The edge termination region may comprise a source terminal having one or more source trench regions.

The semiconductor device may comprise a metal-oxide semiconductor field-effect transistor (MOSFET).

According to a further aspect of the disclosure, there is provided a method of manufacturing an active region of a semiconductor power device, the method comprising:
forming at least two split-gate trench regions within a semiconductor region, wherein two laterally adjacent split-gate trench regions are separated by a mesa region;
etching a gate conductive region within an upper region of each split-gate trench region;
forming at least two insulating plug regions over the etched gate conductive regions, each insulating plug region being formed within a split-gate trench region; and
etching the semiconductor region within the mesa region between two adjacent split-gate trench regions.

Forming at least two insulating plug regions over the etched gate conductive region within the split-gate trench regions may comprise forming an insulating region over an entire surface of the active area and planarising the insulating region to form the insulating plug region.

Etching the gate conductive region may comprise etching the gate conductive region such that an upper surface of the gate conductive region is substantially below an upper surface of the semiconductor region.

Etching the semiconductor region may comprise etching the semiconductor region within the mesa region between two adjacent split-gate trench regions such that an upper surface of the mesa region is substantially below an upper surface of the insulating plug regions. This allows an etchant process used to form the insulating spacer regions to self-terminate on the semiconductor region within the mesa region whilst leaving the insulating spacers.

The method may further comprise forming at least two insulating spacer regions over the etched mesa region of the semiconductor region and adjacent to the insulating plug regions, and etching a recess within the mesa region of the semiconductor region, wherein the recess is defined by the insulating spacer regions. This ensures an accurate and reliable location of the etched recess.

Forming at least two insulating spacer regions may comprise forming an insulating layer over the at least two insulating plug regions and the mesa region between the at least two split-gate trench regions, and etching the insulating layer using an etch process that terminates on an upper surface of the semiconductor region within the mesa region.

The method may further comprise implanting a dopant of a second conductivity type into the semiconductor substrate below the etched recess.

The method may further comprise depositing a conductive material in the etched recess to form a source contact.

According to a further aspect of the disclosure, there is provided a method of manufacturing a semiconductor power device comprising manufacturing an active region of the semiconductor power device as described above, and simultaneously manufacturing an edge termination region.

The edge termination region may comprise a gate terminal having one or more split-gate trench regions. The split-gate trench regions of the gate terminal may be formed in a same process as the split-gate trench regions of the active region.

The edge termination region may comprise a source terminal having one or more source trench regions. The source trench regions of the source terminal may be formed in a same process as the split-gate trench regions of the active region.

The device and method of manufacture of the present disclosure has the following advantages over state-of-the-art devices:
- The device has the improved performance and efficiency of a split-gate MOSFET, whilst having an accurately aligned contact in the active area;
- Spacers formed of an insulating material (for example, an oxide such as silicon dioxide) are built around a gate-plug dielectric. The spacers are used to etch an accurately aligned contact relative to the main trench network;
- The highly accurate self-alignment of the etched recess for the source metal contact and doped contact region relative to the trenches in the active area of the device allows optimal device performance through balanced current flow in the ON-state as well as the OFF-state during unclamped current switching events;
- The method of manufacture is compatible with both an oxide gate-plug or nitride gate-plug to build the spacers;
- The manufacturing steps may be performed using materials and processing equipment commonly available in MOSFET fabs;
- The double-recess etch steps of the method used to form the plug dielectric may be performed using etch chemistries also used for planarising the gate polysilicon region and etching the source contact recess;
- Edge termination contacts are fully integrated allowing gate terminals, source-poly terminals and source-mesa terminals to be manufactured at the same time in a single set of processing steps.

### Brief Description of the Drawings

Some embodiments of the disclosure will now be described, by way of example only and with reference to the accompanying drawings, in which:
Figure 1 shows schematically a cross-section of a MOSFET according to an embodiment of the disclosure;
Figure 2 shows steps in a method of manufacturing a MOSFET according to an embodiment of the disclosure;
Figure 3 shows schematically a cross-section of an active area of a MOSFET according to an embodiment of the disclosure, in which the spacers are formed over an oxide plug;
Figure 4 shows schematically a cross-section of an active area of an alternative MOSFET according to an embodiment of the disclosure, in which the spacers are formed over a nitride plug;
Figure 5 shows schematically a cross-section of gate terminal contacts within an edge termination region of a MOSFET according to an embodiment of the disclosure;
Figure 6 shows schematically a cross-section of source terminal contacts within an edge termination region of a MOSFET according to an embodiment of the disclosure;
Figure 7 illustrates steps of a method of manufacturing an active area of a MOSFET according to an embodiment of the disclosure;
Figure 8 illustrates steps of a method of manufacturing an active area of an alternative MOSFET in which the spacers are formed over a nitride plug, according to an embodiment of the disclosure;
Figure 9 illustrates steps of a method of manufacturing gate terminal contacts within an edge termination region of a MOSFET according to an embodiment of the disclosure; and
Figure 10 illustrates steps of a method of manufacturing source terminal contacts within an edge termination region of a MOSFET according to an embodiment of the disclosure.

### Detailed Description of the Preferred Embodiments

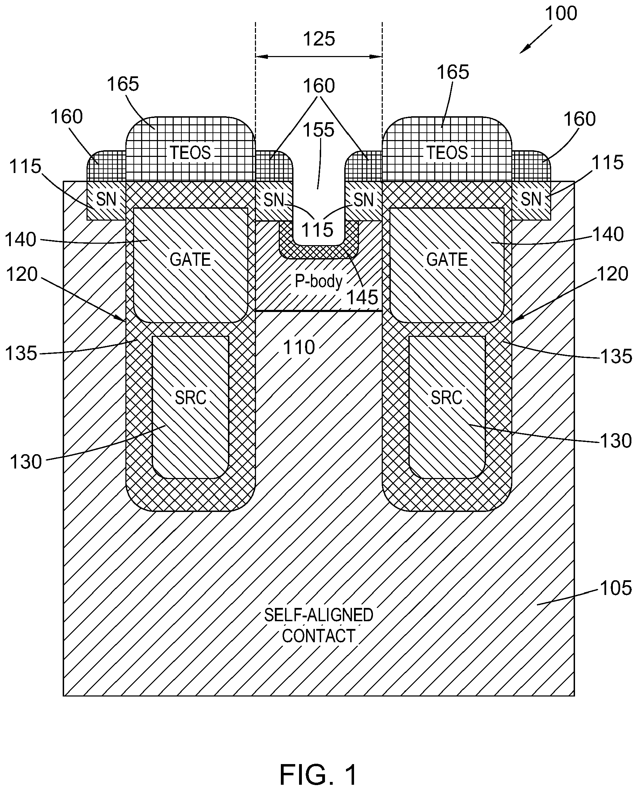

Figure 1 shows schematically a cross-section of an active area 100 of a semiconductor device, according to an embodiment of the disclosure. In the examples herein described, the device is a silicon based split-gate trench MOSFET. However, the skilled person would understand that the device may comprise alternative semiconductor materials; for example, the device may be silicon carbide (SiC) or Gallium Nitride (GaN based. The device may be also an insulated gate bipolar transistor (IGBT).

The active area 100 includes an n-type voltage sustaining region (or n-drift region) 105 formed on or over a semiconductor substrate. In this example, the n-drift region 105 is an epitaxial layer. Whilst not shown, the device may include a drain or collector region located underneath the drift region 105. In the example shown, the device includes two gate trenches 120 each extending downwardly into the n-drift region 105 from an upper surface of an n+ contact region 115. During operation, a conduction channel is formed between the n+ contact region 115 and the drift region 105 by application of a positive voltage to the gate.

The two gate trenches 120 are formed, which are laterally spaced from each other. Whilst two gate trenches 120 are shown for example only, it will be appreciated that the device may include more gate trenches. Each gate trench 120 includes an insulation layer 135 formed along the inner sidewalls and the lower surface of the gate trench 120. In this example the insulation layer 135 is an oxide layer (e.g. silicon dioxide), though other insulating materials may be used. In examples where the insulation layer 135 is a silicon dioxide liner, the silicon dioxide liner 135 may be thermally grown and/or deposited. In one example, a first portion of the insulation layer 135 is thermally grown (e.g. 5% of the insulation layer) and the remaining portion of the insulation layer 135 is deposited over the thermally grown portion.

The gate trenches 120 have a split-gate structure including a gate conductive, polysilicon region 140 formed in an upper portion of each trench 120, and a trench shield 130 (or source polysilicon region) formed in a lower portion of each trench 120. The gate polysilicon region 140 and the trench shield 130 of each trench are separated by the insulation layer 135.

Along the upper portion, the insulation layer is thinner and the gate conductive region 140 defines a vertical channel. In a lower portion of the gate trenches 120 the insulation layer is thicker than in the upper portion, therefore the conductive source polysilicon region 130 acts as a fieldplate at source potential and is insulated by the thicker insulation layer from the drain region of the device. The conductive region 140 and the trench shield 130 may be formed of a conducting material, such as metal or doped polysilicon.

Above the n-drift region 105, and adjacent to and between the two gate trenches 120, there is provided a p-body region 110. The p-body region 110 is a p-type doped semiconductor and generally extends to a depth in the device which corresponds with the depth of the gate conductive region 140. The depth of the p-body region 110 may be less than the depth of the gate conductive region 140 in order to ensure that the gate conductive region 140 is able to provide switching along the full length of the p-body region 110. The n+ contact region 115 is provided above the p-body region 110.

The two adjacent gate trenches 120 are separated by a mesa region. A p+ contact region 145 is formed within the mesa region within the p-body region 110 and below the source contact 155.

A source contact 155 is formed within the mesa region 125 laterally between adjacent trenches 120 and extending from an upper surface of the device towards the p-body region 110. In order to align the source contact 155 within the mesa region, spacers 160 formed of an insulating material are located over the n+ contact region 115 on either side of each gate trench 120. Additionally, the p+ contact region 145, also referred to as the contact implant, is auto-aligned by the spacers 160.

A further insulator region (or plug dielectric) 165 is located over the surface of each gate trench 120 between two spacers 160. The plug dielectric 165 extends or projects above an upper surface of the semiconductor substrate. The plug dielectric 165 acts as a separator or isolator between the gate and the source contact 155, and due to its thickness can support the necessary drain-to-source breakdown voltage (BV_{dss}) in the edge termination region of a RESURF device.

The spacers 160 are formed around the plug dielectric 165 and are used to etch an accurately aligned source contact 155 relative to the gate trenches 120. The spacers 160 built or formed around the proud or projecting plug dielectric 165 provide consistent alignment of the source 155 contact relative to the gate trenches 120 with significantly reduced misalignment and a large process window. In this example, the spacers 160 are formed of an oxide region, for example, silicon dioxide. The plug dielectric 165 may be formed of TEOS.

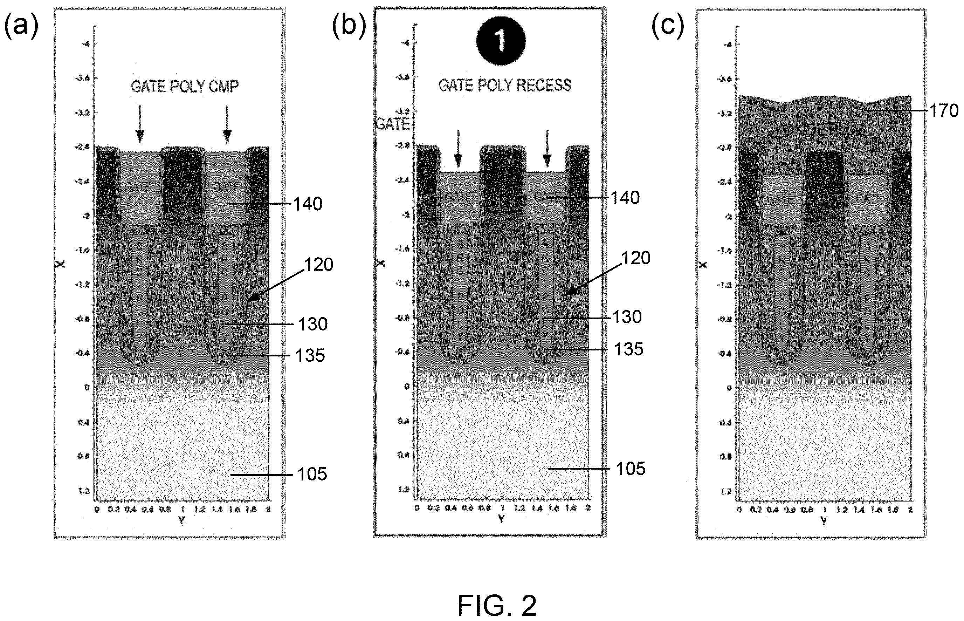

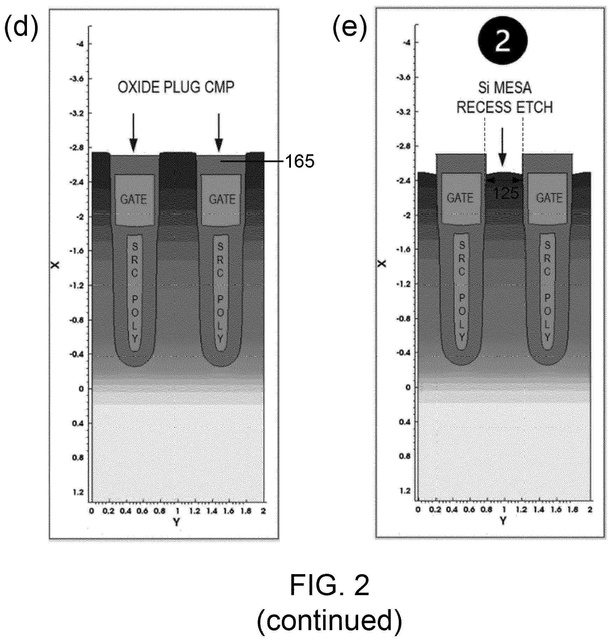

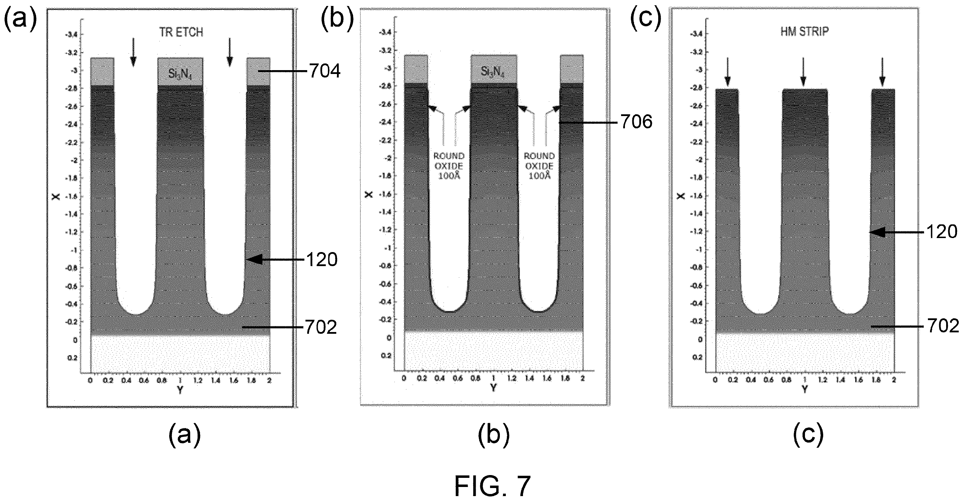

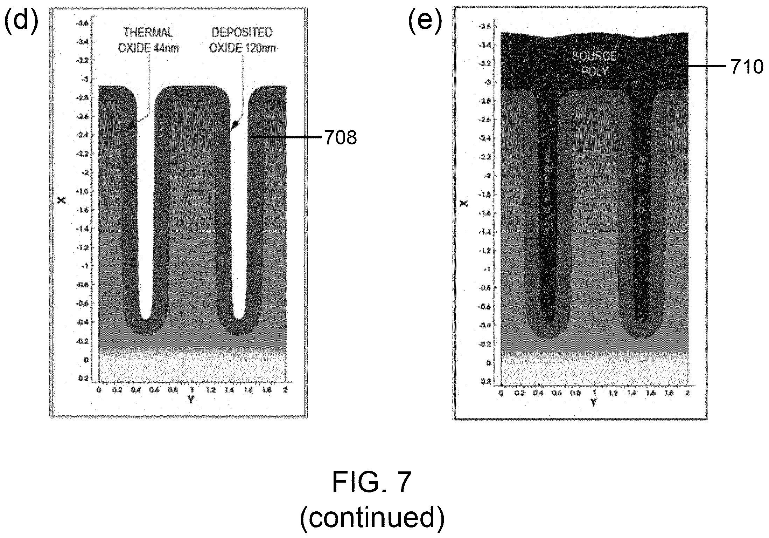

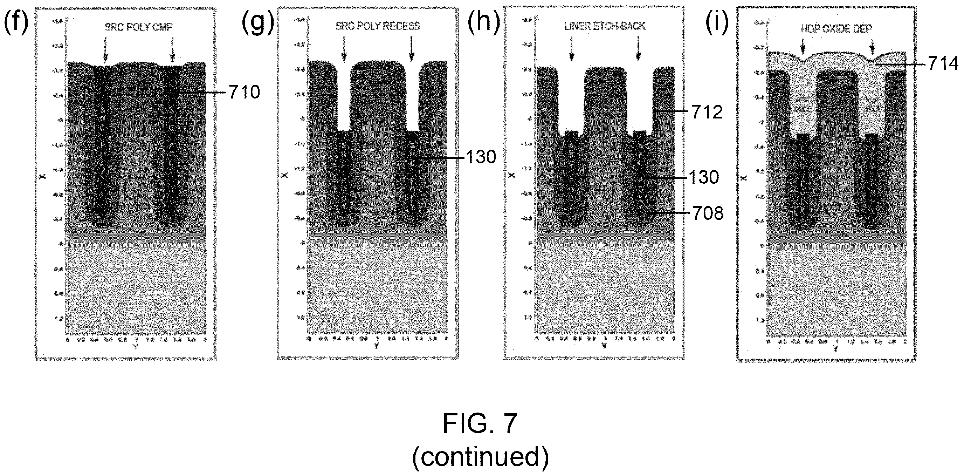

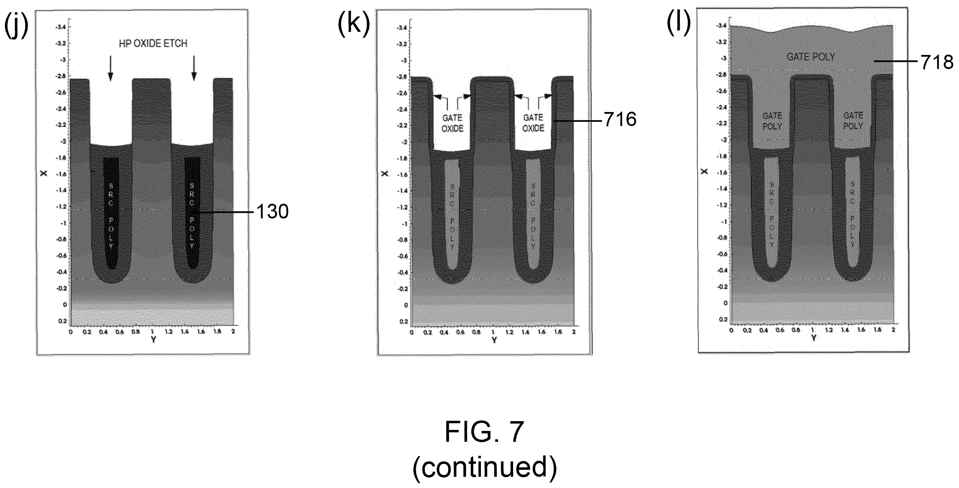

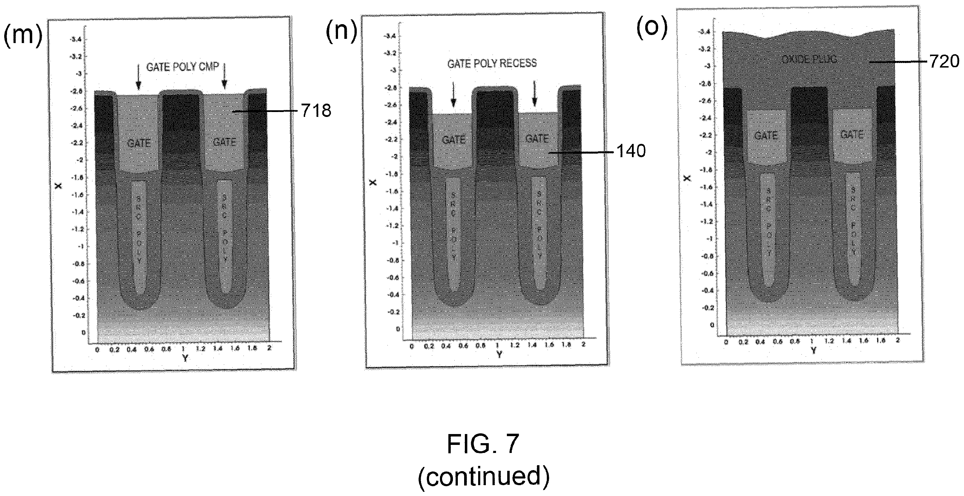

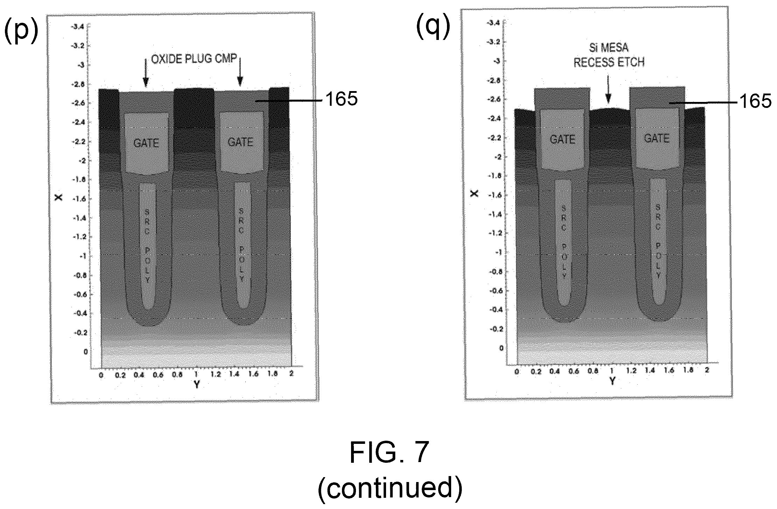

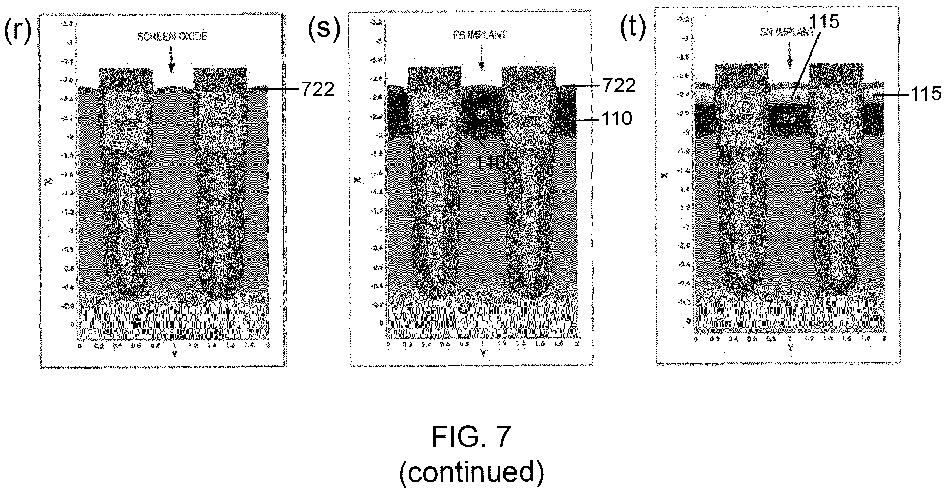

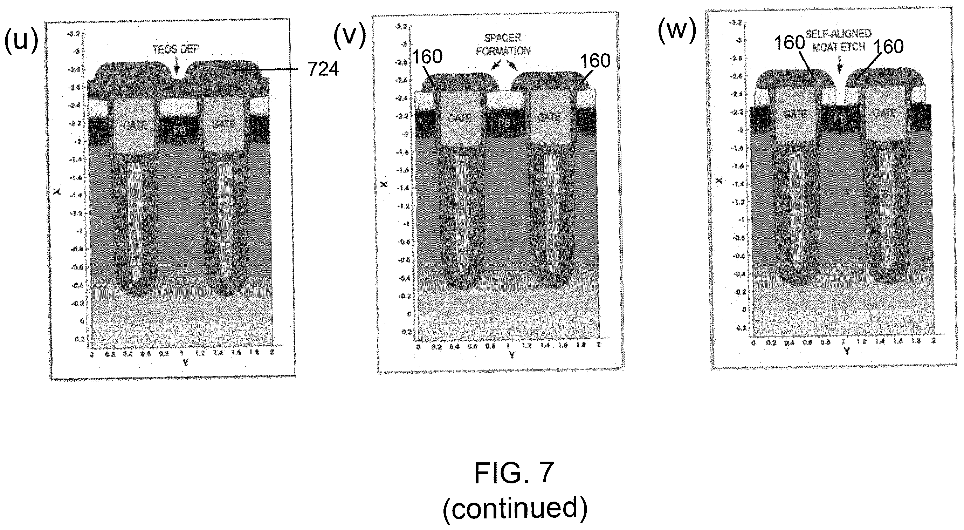

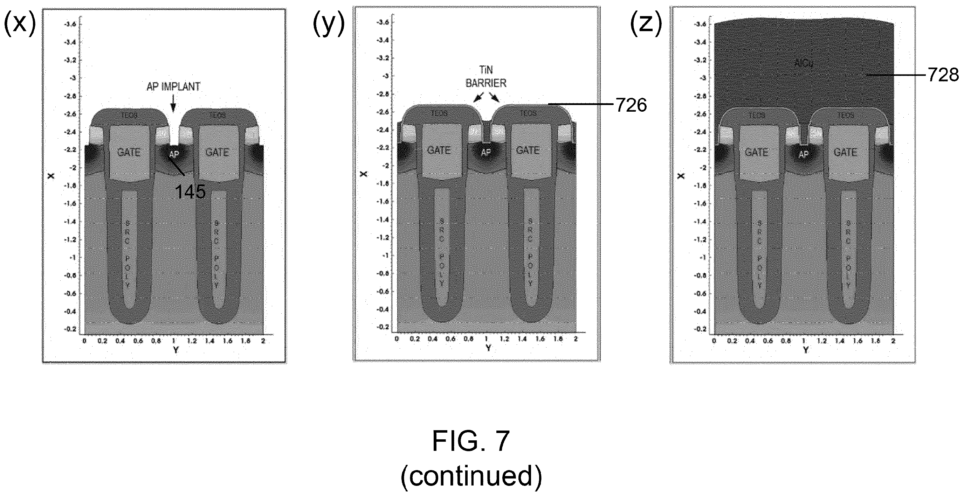

Figures 2(a) to 2(e) show steps in a method of manufacturing a split-gate MOSFET according to an embodiment of the disclosure, such as the active area of the MOSFET shown in Figure 1. Many of the features shown in Figure 2 are similar to those shown in Figure 1 and therefore carry the same reference numerals. It will be appreciated that the steps shown in Figure 2 illustrate a subset of all the steps for manufacturing a device, and that the method may further include additional steps preceding or following the steps of Figure 2, such as those shown in Figures 7 to 10. Whilst Figures 2(a) to 2(e) show steps in manufacturing an active area having two gate trenches 120, it will be understood that the method may be used to manufacture more than two gate trenches.

Figure 2(a) illustrates a first step of manufacturing a split-gate MOSFET, which is as follows:
- The conductive polysilicon region 140 is planarised using chemical mechanical planarization (CMP). This removes excess materials and creates a smooth surface on the upper surface of the conductive polysilicon region 140 such that the conductive polysilicon region 140 has an upper surface substantially aligned with the upper surface of the mesa region.

Figure 2(b) illustrates a second step of manufacturing a split-gate MOSFET, which is as follows:
- A first etching step is performed to etch the conductive polysilicon region 140 within each gate trench 120 such that the conductive polysilicon region 140 is recessed below the upper surface of the device and the mesa region.

Figure 2(c) illustrates a third step of manufacturing a split-gate MOSFET, which is as follows:
- A thick oxide layer 170 is formed or deposited over an upper surface of the device, filling the recesses formed in the step shown in Figure 2(b).

Figure 2(d) illustrates a fourth step of manufacturing a split-gate MOSFET, which is as follows:
- The thick oxide layer 170 is planarised using chemical mechanical planarization (CMP) to form the insulating plug region 165. This removes excess materials and creates a smooth surface on the upper surface of the insulating plug region 165 such that the insulating plug region 165 has an upper surface substantially aligned with the upper surface of the mesa region.

Figure 2(e) illustrates a fifth step of manufacturing a split-gate MOSFET, which is as follows:
- The silicon mesa region 125 located between adjacent gate trenches 120 is etched, to form a recess between adjacent insulating plug regions 165 located above adjacent gate trenches 120.

This double recess-etch process allows the formation of the projecting plug dielectric region 165, which in turn allows the formation of the insulating spacers 160. The plug dielectric region 165 is formed over the gate polysilicon region 140 and is formed from either SiO₂ or Si₃N₄ after forming the gate polysilicon region 140.

The double recess-etch process includes (i) etching the gate polysilicon 140 within the gate trenches 120, followed by (ii) etching the silicon in the mesa region 125 between adjacent trenches 120. The insulating spacers 160 act to align the source contact 155 in the active area of the device, by functioning as a hard mask during the steps of etching the recess for the source contact 155 and implanting the p+ contact region 145. The disclosed device and method of manufacture removes the requirement for critical alignments when etching a recess for the source metal contact 155 and implanting the p+ source contact region 145. This improves stability and repeatability of manufactured devices.

The dry-etch steps shown in Figures 2(b) and 2(e) may be performed using HBr/O₂ dry-etch chemistries that have a Si/dielectric selectivity in the range 10-50:1. This may use dry etch-chemistries also deployed for planarisiation of the gate polysilicon region 140 shown in Figure 2(a) and etching the recess for the source contact 155, as shown in Figure 7(w).

While the etch-back of the gate polysilicon region 140 shown in Figure 2(b) is tolerant to the creation of micro-topography over the gate polysilicon region 140, defect-free etched depths of 400nm can be achieved using the etch processes shown in Figures 2(b) and 2(e).

The etching of the epitaxial silicon in the mesa region shown in Figure 2(e) using HBr/O₂ dry-etch chemistries ensures that the bottom of the etched recess has a smooth finish, that is substantially free of pits and micro-structures. This ensures that the finish of the surface of the mesa region produced after the etch process of Figure 2(e) is indistinguishable from an as-delivered epitaxially grown surface finish.

The outer sidewalls of the trenches 120 are formed of an oxide dielectric and are therefore highly resistant to etching using HBr/O₂ dry-etch chemistries. However, any micro topography can be removed or repaired by growing and removing a thin oxide layer (~300Å).

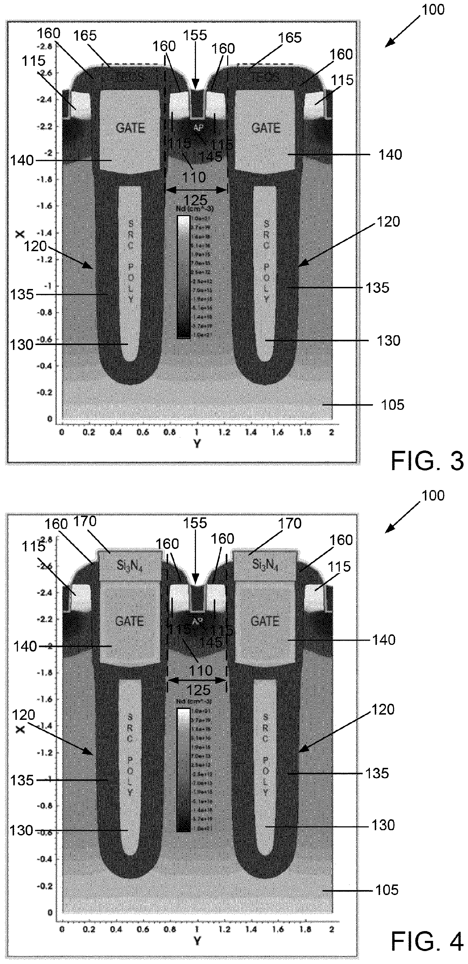

Figure 3 shows a cross-section of an active area 100 of a MOSFET, in which the insulating spacers 160 are formed over an oxide plug region 165, and Figure 4 shows schematically a cross-section of an active area 100 of an alternative MOSFET, in which the insulating spacers 160 are formed over a nitride plug region 170. Many of the features shown in Figures 3 and 4 are similar to those shown in Figures 1 and 2 and therefore carry the same reference numerals. Figures 3 to 6 show a simulated doping concentration of the illustrated devices. The method of Figure 2 is compatible with both forming an oxide dielectric plug 165 or a nitride dielectric plug 170, before forming the spacers 160.

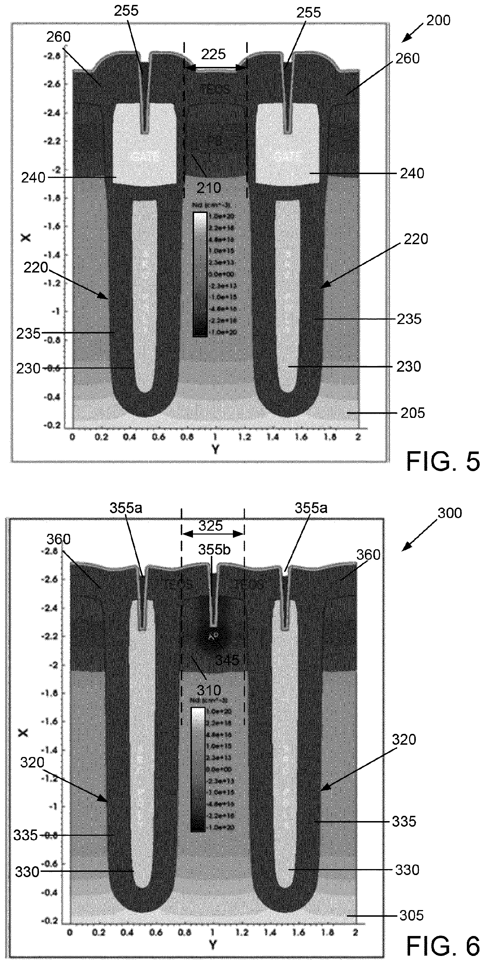

Figure 5 shows schematically a cross-section of a gate terminal within an edge termination region 200 of a MOSFET according to an embodiment of the disclosure. It will be understood that the edge termination region 200 shown in Figure 5 may be formed in the same device as an active area 100 of a MOSFET, such as that shown in Figures 1 to 4. The edge termination region and the edge termination contacts shown in Figures 5 and 6 can be fully integrated allowing gate, source-poly and source-mesa terminals to be manufactured simultaneously in the same set of processing steps.

The edge termination region 200 includes an n-type voltage sustaining region (or n-drift region) 205. In this example, the n-drift region 205 is an epitaxial layer. Whilst not shown, the device may include a drain or collector region located underneath the drift region 205. The device includes two gate trenches 220 each extending downwardly into the n-drift region 205. Whilst two gate trenches 220 are shown for example only, it will be appreciated that the device may include more than two gate trenches.

The two gate trenches 220 are formed, which are laterally spaced from each other. Whilst two gate trenches 220 are shown for example only, it will be appreciated that the device may include more gate trenches. Each gate trench 220 includes an insulation layer 235 formed along the inner sidewalls and the lower surface of the gate trench 220. In this example the insulation layer 235 is an oxide layer (e.g. silicon dioxide), though other insulating materials may be used. In examples where the insulation layer 235 is a silicon dioxide liner, the silicon dioxide liner 235 may be thermally grown and/or deposited.

The gate trenches 220 have a split-gate structure including a conductive, polysilicon region 240 formed in an upper portion of each trench 220, and a trench shield 230 formed in a lower portion of each trench 220. The polysilicon region 240 and the trench shield 230 of each trench are separated by the insulation layer 235. The conductive region 240 and the trench shield 230 may be formed of a conducting material, such as metal or doped polysilicon.

Above the n-drift region 205, and adjacent to and between the two gate trenches 220, there is provided a p-body region 210. The p-body region 210 is a p-type doped semiconductor and generally extends to a depth in the device which corresponds with the depth of the gate conductive region 240.

The two adjacent gate trenches 220 are separated by a mesa region 225. An insulation layer 260 is formed over an upper surface of the gate trenches 220 and the p-body region 210 within the mesa region. Two gate contacts 255 are formed, each extending through the insulating layer 260 to the conductive, polysilicon region 240 of each gate trench 240.

Figure 6 shows schematically a cross-section of a source terminal within an edge termination region 300 of a MOSFET according to an embodiment of the disclosure. It will be understood that the edge termination region 300 shown in Figure 6 may be formed in the same device as an active area 100 of a MOSFET, such as that shown in Figures 1 to 4 and another edge termination region 200, such as that shown in Figure 5.

The edge termination region 300 includes an n-type voltage sustaining region (or n-drift region) 305. In this example, the n-drift region 305 is an epitaxial layer. Whilst not shown, the device may include a drain or collector region located underneath the drift region 305. The device includes two auxiliary trenches 320 (or dummy trenches) each extending downwardly into the n-drift region 305. Whilst two auxiliary trenches 320 are shown for example only, it will be appreciated that the device may include more than two auxiliary trenches.

The two auxiliary trenches 320 are formed, which are laterally spaced from each other. Whilst two auxiliary trenches 320 are shown for example only, it will be appreciated that the device may include more auxiliary trenches. Each auxiliary trench 320 includes an insulation layer 335 formed along the inner sidewalls and the lower surface of the auxiliary trench 320. In this example, the insulation layer 335 is an oxide layer (e.g. silicon dioxide), though other insulating materials may be used. In examples where the insulation layer 335 is a silicon dioxide liner, the silicon dioxide liner 335 may be thermally grown and /or deposited.

The auxiliary trenches 320 have a trench shield 330 formed throughout the depth of the auxiliary trenches 320. The trench shield 330 may be formed of a conducting material, such as metal or doped polysilicon.

Above the n-drift region 305, and adjacent to and between the two auxiliary trenches 320, there is provided a p-body region 310. The p-body region 310 is a p-type doped semiconductor. The two adjacent auxiliary trenches 320 are separated by a mesa region. A highly doped p+ contact region 345 is formed within the mesa region within the p-body region 310.

An insulation layer 360 is formed over an upper surface of the auxiliary trenches 320 and the p-body region 310 within the mesa region 325. Three source contacts 355 are formed, each extending through the insulating layer 360. Two of the source contacts 355a extend to the trench shield 330 of each auxiliary trench 340, and a third source contact 355b extends to the p+ contact region 345 within the mesa region.

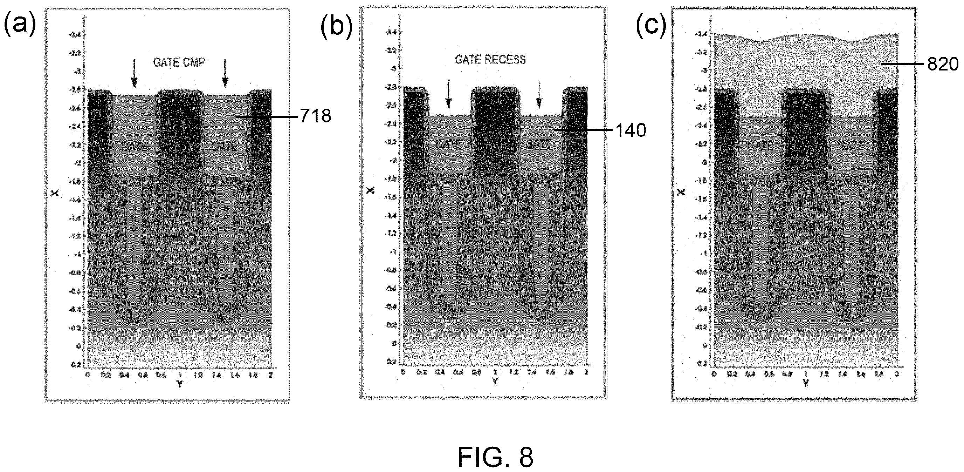

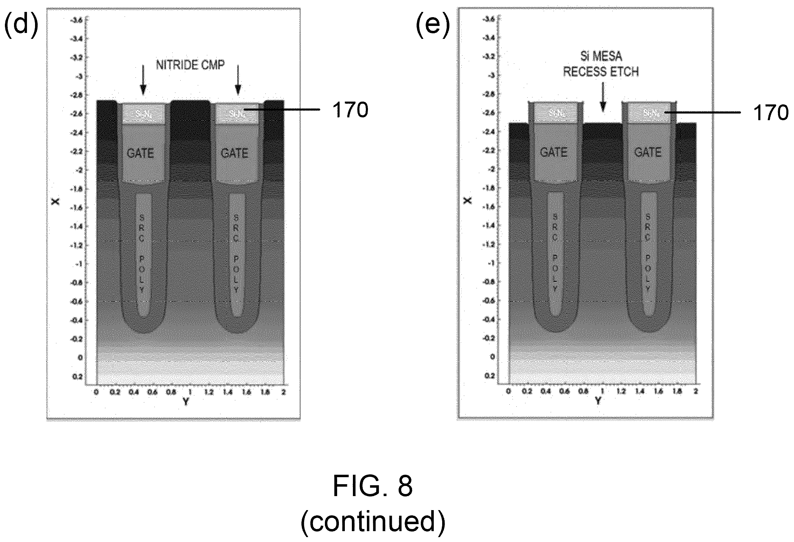

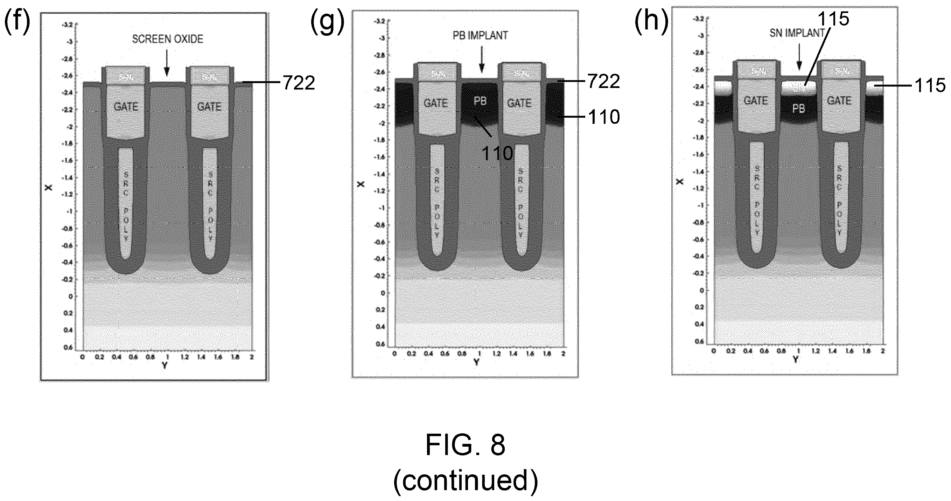

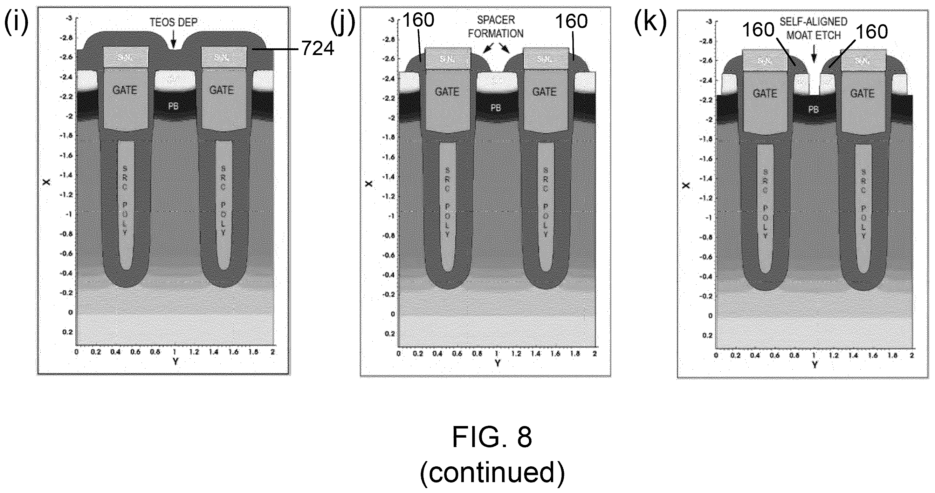

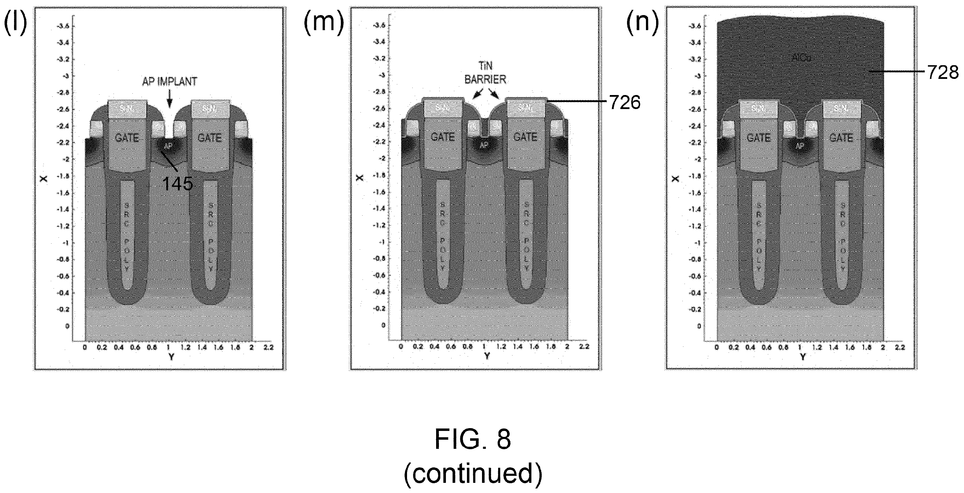

Figures 7(a) to 7(z) illustrate steps of a method of manufacturing an active area 100 of a MOSFET according to an embodiment of the disclosure, such as the active area shown in Figures 1 and 3. Many of the features are the same as those shown in Figures 1 to 3 and therefore carry the same reference numerals. It will be appreciated that the steps shown in Figure 7 may illustrate a subset of all the steps for manufacturing a device, and that the method may further include additional steps preceding or following the steps of Figure 7. It will also be appreciated that Figures 7(m) to 7(q) represent the same steps as shown in Figures 2(e) to 2(e). Whilst Figures 7 and 8 show steps in manufacturing an active area having two gate trenches 120, it will be understood that the method may be used to manufacture more than two gate trenches.

The steps of the method shown in Figure 7 are performed in order from (a) to (z) as follows:
(a) Two trenches 120 are dry etched in a semiconductor region. In this example, the semiconductor region includes a substrate having epitaxial layers over the substrate. In the example shown, the semiconductor region comprises a silicon region 702 having a nitride layer 704 located over the silicon region 702. The nitride layer may be Si₃N₄ and acts as a hard mask or resist layer to define the trenches during the dry-etch process;
(b) A thin rounding oxide layer 706 is formed on the inner walls of the each trench 120. The thin rounding oxide layer 706 is grown and immediately stripped. This cleans up any micro-imperfections on the sidewalls of the trenches that were introduced during the preceding dry etch step shown in Figure 7(a), and rounds any sharp corners of the trenches. In the example shown, the thin rounding oxide layer 706 has a thickness of in the range 100-800Å;
(c) A hardmask strip process is performed to remove the nitride layer from the silicon substrate 702;
(d) A thin oxide layer is thermally grown on the inner walls and lower surface of each trench and over the upper surface of the mesa region between adjacent trenches. A thicker oxide layer is deposited over the thin oxide layer. The dual-oxide layer 708 is formed in this two-stage process to control the doping inside the mesa region 125. The thin oxide layer may have a thickness of between 20-500nm, and the thick oxide layer may have a thickness between 80-1000nm to provide an oxide liner 708 of between 100 to 1500nm thickness. In the example shown, the thin oxide layer may have a thickness of approximately 44nm, and the thick oxide layer may have a thickness of approximately 120nm to provide an oxide liner 708 of approximately 164nm thickness;
(e) Source polysilicon 710 is formed within the two trenches and over an upper surface of the device;
(f) The source polysilicon 710 is planarised using chemical mechanical planarization (CMP);
(g) An etching process is performed to etch the source polysilicon 710 within the trenches, such that the source polysilicon 710 is recessed below the upper surface of the trenches and forms the trench shield 130;
(h) A further etching process is performed to etch back the oxide layer in the mesa region and along the sidewalls of the trenches above the source polysilicon, such that both the thick oxide liner 708 (in this example, having a thickness of approximately 164nm) remains along the sidewalls adjacent to the source polysilicon 710, but only a thin oxide layer 712 remains along the mesa region and the sidewalls of the trenches at a shallower depth than the source polysilicon, where the thin oxide layer 712 has a thickness substantially less than the thick oxide liner 708;
(i) Further oxide 714 is deposited within the trenches using high-density-plasma chemical vapour deposition, over the source polysilicon within the trenches;
(j) A high precision etch process is performed to etch the surface of the further oxide 714 deposited within the trenches above the trench shield 130 in step (i), and to remove all the thin oxide layer 712 along an upper portion of both sidewalls of each trench;
(k) A further thin oxide layer 716 is then formed along the upper portions of the sidewalls of each trench by oxidising the silicon region;
(l) A conductive polysilicon region 718 is deposited over the device and within each trench;
(m) The conductive polysilicon region 718 is planarised using chemical mechanical planarization (CMP) or using a planarising dry-etch step;
(n) An etching step is performed to etch the conductive polysilicon region 718 within each gate trench such that the conductive polysilicon region 718 is recessed below the mesa region. This forms the gate polysilicon region 140;
(o) A further thick oxide layer 720 or plug is formed or deposited over an upper surface of the device;
(p) The thick oxide layer 720 is planarised using chemical mechanical planarization (CMP) to form the insulating plug region 165;
(q) The silicon mesa region located between adjacent gate trenches is etched, to form a recess between the adjacent gate trenches;
(r) A screen oxide layer 722 is grown or deposited over an upper surface of the device;
(s) A p-type dopant is implanted into the mesa region, below the screen oxide layer 722 to form the p-body region 110;
(t) A n-type dopant is implanted into the mesa region, above the p-body region 110 and below the screen oxide layer 722 to form the n+ contact region 115;
(u) An oxide layer 724, in this example silicon dioxide (e.g. Tetraethyl orthosilicate (TEOS)), is deposited over an upper surface of the device in a furnace or in a low pressure chemical vapor deposition (LPCVD) tool. Alternatively, a similar insulating layer (e.g. BPSG glass) may be deposited or undoped silicon glass is deposited in a high-density plasma CVD tool;
(v) Spacers are formed by etching the TEOS layer 724 until it end-points and self-terminates at an upper surface of the silicon region 702, in this example on the upper surface of the n+ contact region 115. This step etches the TEOS (or other insulator) layer 724 until an end-point is reached when the etch has removed all the TEOS layer 724 in one region and begins to etch the silicon region 702. In examples, this step can be self-terminating as the etch process transitions from etching the TEOS layer 724 to etching the silicon region 702;
(w) A moat or recess is etched through the n+ contact region 115 within the mesa region 125, extending down to the p-body region 110. This self-aligned etching process is limited by the spacers 160 and thus the alignment of the recess relative to the trenches 120 is defined by the spacers 160. As the etched recess is defined by the spacers 160, this removes the requirement for critical alignments when etching the recess for the source contact 155 and implanting the p+ contact region 145;
(x) A p-type dopant (for example, Boron) is implanted below the recess and in the p-body region 110, to form the p+ contact region 145. The p+ contact region 145, also referred to as the contact implant, is auto-aligned by the spacers 160. The p+ contact region 145 is annealed after implantation;
(y) A metal barrier layer 726, such as a Titanium or Titanium Nitride (Ti/TiN) is deposited over the surface of the device and annealed;
(z) A metal contact layer 728, in this example an aluminium-copper alloy, is formed over the device by sputtering. The metal contact layer 728 extends into the etched recess.

Figure 8 illustrates steps of a method of manufacturing an active area 100 of an alternative MOSFET according to an embodiment of the disclosure, in which the spacers are formed over a nitride plug such as the active area shown in Figure 4. Many of the features are the same as those shown in Figure 4 and therefore carry the same reference numerals. It will be appreciated that the steps shown in Figure 8 may illustrate a subset of all the steps for manufacturing a device, and that the method may further include additional steps preceding or following the steps of Figure 8. In particular, it is noted that the steps shown in Figures 7(a) to 7(l) may precede the steps shown in Figure 8.

The steps of the method shown in Figure 8 performed in order from (a) to (n) as follows as follows:
(a) The conductive polysilicon region 718 is planarised using chemical mechanical planarization (CMP) or planarising dry-etch step;
(b) An etching step is performed to etch the conductive polysilicon region 718 within each gate trench such that the conductive polysilicon region 718 is recessed below the mesa region. This forms the gate polysilicon region 140;
(c) A further thick nitride layer 820 or plug is formed or deposited over an upper surface of the device;
(d) The thick nitride layer 820 is planarised using chemical mechanical planarization (CMP) to form the insulating nitride plug region 170;
(e) The silicon mesa region located between adjacent gate trenches is etched, to form a recess between the adjacent gate trenches;
(f) A screen oxide layer 722 is grown or deposited over an upper surface of the device;
(g) A p-type dopant is implanted into the mesa region, below the screen oxide layer 722 to form the p-body region 110;
(h) A n-type dopant is implanted into the mesa region, above the p-body region 110 and below the screen oxide 722 layer to form the n+ contact region 115;
(i) An oxide layer 724, in this example silicon dioxide (e.g. Tetraethyl orthosilicate (TEOS)), is deposited over an upper surface of the device in a furnace or in a low pressure chemical vapor deposition (LPCVD) tool. Alternatively, a similar insulating layer (e.g. BPSG glass) may be deposited or undoped silicon glass is deposited in a high-density plasma CVD tool;
(j) Spacers are formed by etching the TEOS layer 724 until it end-points and self-terminates at an upper surface of the silicon region 702, in this example on the upper surface of the n+ contact region 115. This step etches the TEOS (or other insulator) layer 724 until an end-point is reached when the etch has removed all the TEOS layer 724 in one region and begins to etch the silicon region 702. In examples, this step can be self-terminating as the etch process transitions from etching the TEOS layer 724 to etching the silicon region 702;
(k) A moat or recess is etched through the n+ contact region 115 within the mesa region 125, extending down to the p-body region 110. This self-aligned etching process is limited by the spacers 160 and thus the alignment of the recess relative to the trenches 120 is defined by the spacers 160. As the etched recess is defined by the spacers 160, this removes the requirement for critical alignments when etching the recess for the source contact 155 and implanting the p+ contact region 145;
(l) A p-type dopant is implanted below the recess and in the p-body region 110, to form the p+ contact region 145. The p+ contact region 145, also referred to as the contact implant, is auto-aligned by the spacers 160;
(m) A metal barrier layer 726, such as a Titanium or Titanium Nitride (Ti/TiN) is deposited over the surface of the device and annealed;
(n) A metal contact 728, in this example an aluminium-copper alloy is formed over the device by sputtering. The metal contact 728 extends into the etched recess.

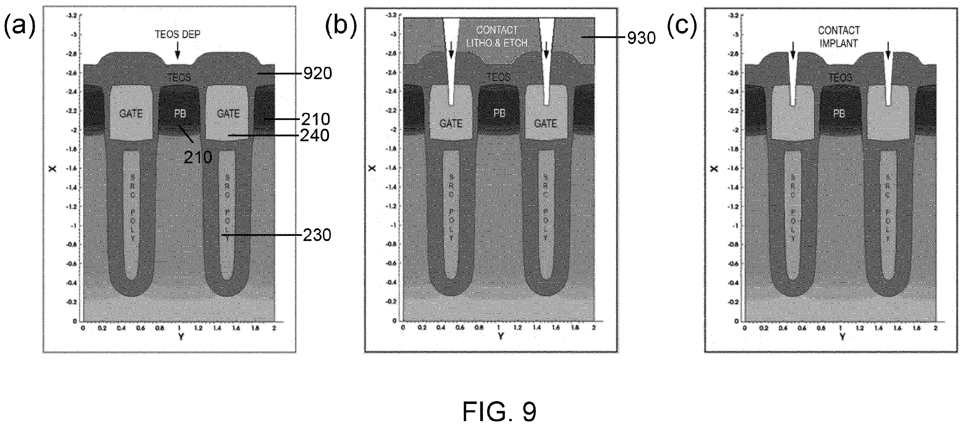

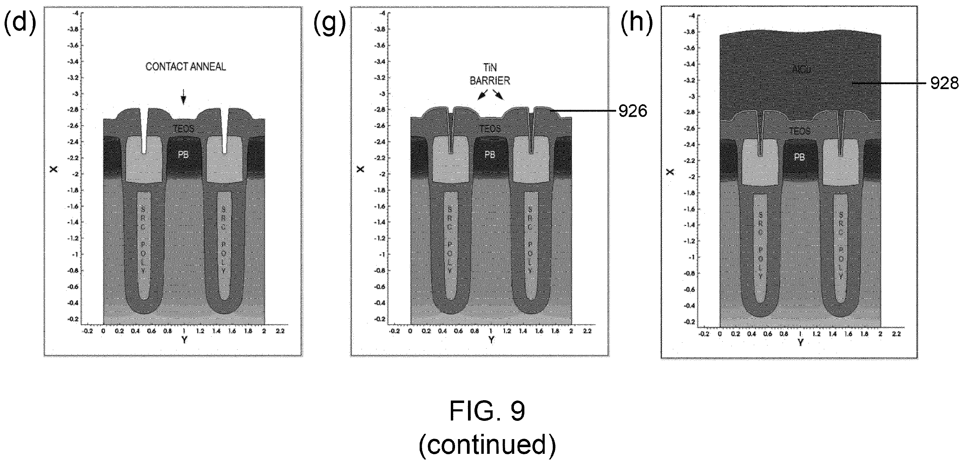

Figure 9 illustrates steps of a method of manufacturing a gate terminal within an edge termination region 200 of a MOSFET according to an embodiment of the disclosure, such as that shown in Figure 5. Many of the features are the same as those shown in Figure 5 and therefore carry the same reference numerals. It will be appreciated that the steps shown in Figure 9 may illustrate a subset of all the steps for manufacturing a device, and that the method may further include additional steps preceding or following the steps of Figure 9. In particular, it is noted that the steps shown in Figures 7(a) to 7(s) may precede the steps shown in Figure 9. The steps shown in Figures 7(a) to 7(u) may be performed in the edge termination region to form the intermediate device shown in Figure 9(a), however a lithography or mask may be used to block implantation within the edge termination region 200 of the n-type dopant used to form the n+ contact region 115 within the active area.

Whilst Figure 9 shows steps in manufacturing edge termination region 200 having two gate trenches, it will be understood that the method may be used to manufacture more than two gate trenches.

The steps of the method shown in Figure 9 are performed in order from (a) to (f) as follows as follows:
(a) An oxide layer 920, in this example silicon dioxide, is deposited over an upper surface of the device. This oxide layer 920 may be deposited in the same process as forming the TEOS layer 724 in the active area in the step shown in Figure 7(u);
(b) A mask 930 defining the location of the gate contacts is formed and an etching process is performed to form two recesses extending through the oxide layer to the conductive, polysilicon region of each gate trench;
(c) A p-type dopant (for example, Boron) is implanted within each recess to form the gate contact. This may be performed in the same step as forming the p+ contact region 145 shown in Figure 7(x);
(d) The gate contacts formed in the step shown in Figure 9(c) are annealed;
(e) A metal barrier layer 926, such as Titanium and/or Titanium Nitride (Ti/TiN) is formed over the surface of the device;
(f) A metal contact 928, in this example an aluminium-copper alloy is formed over the device.

It will be understood that the steps shown in Figure 9 may be performed additionally and/or concurrently with the steps shown in Figures 7 or 8 to form both the active area and edge termination region of a MOSFET device.

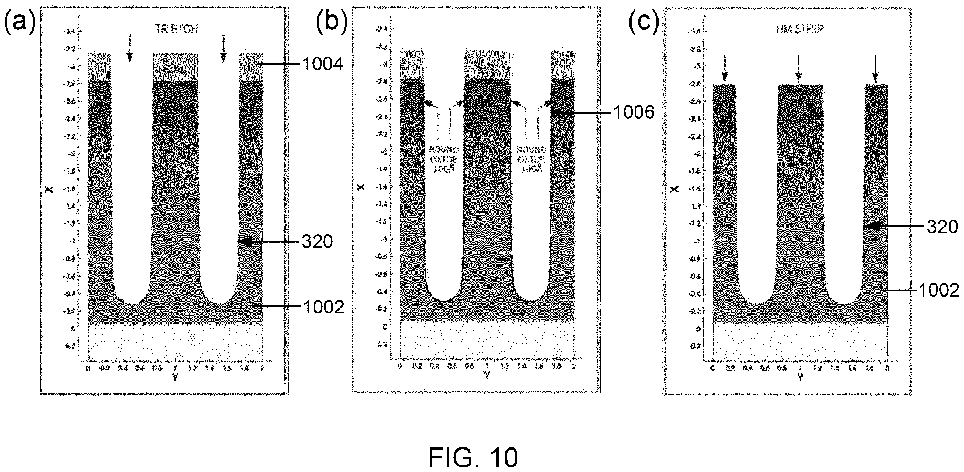

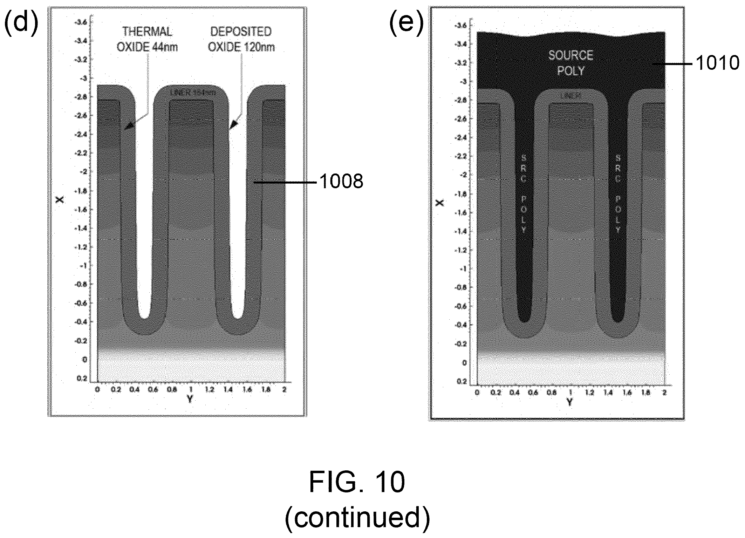

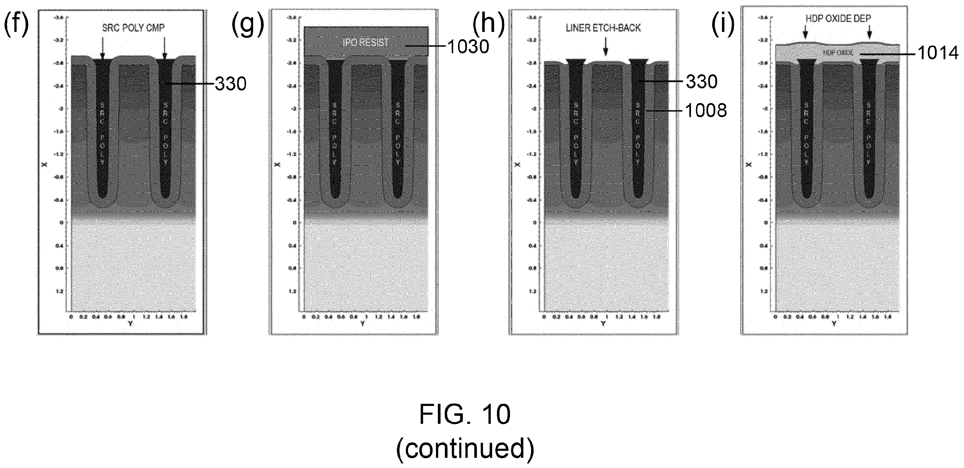

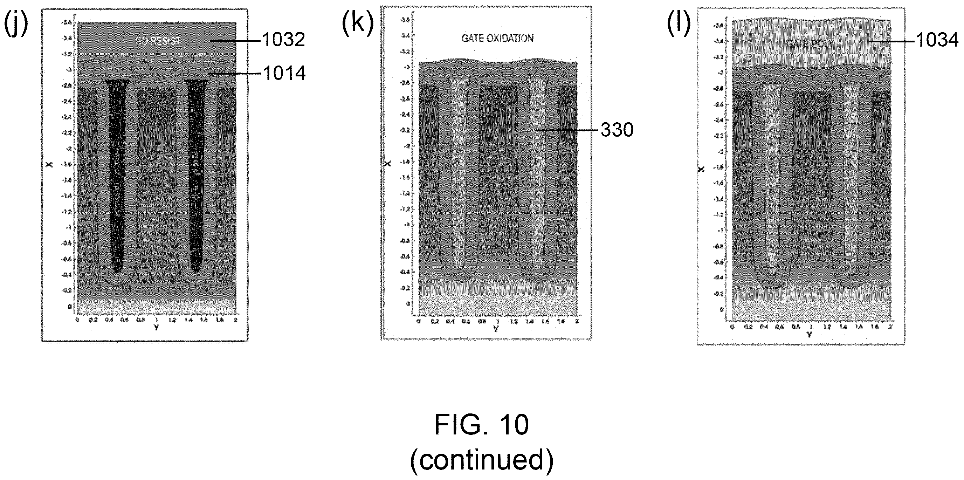

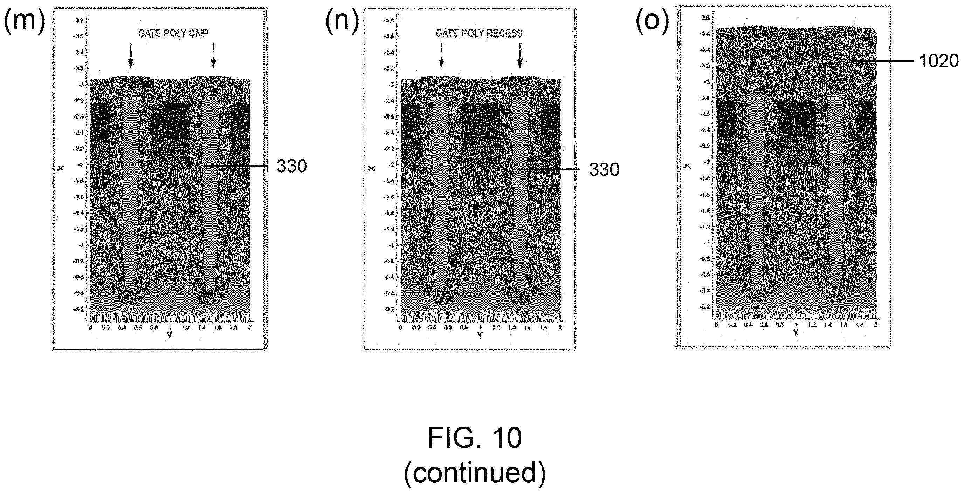

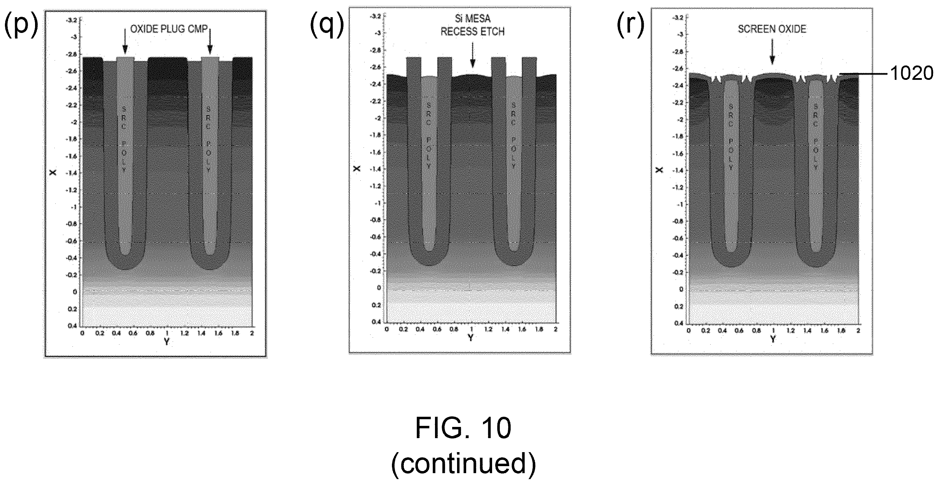

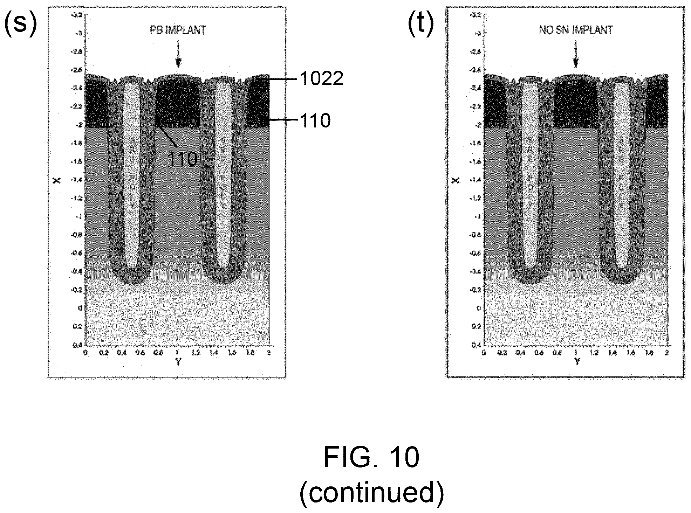

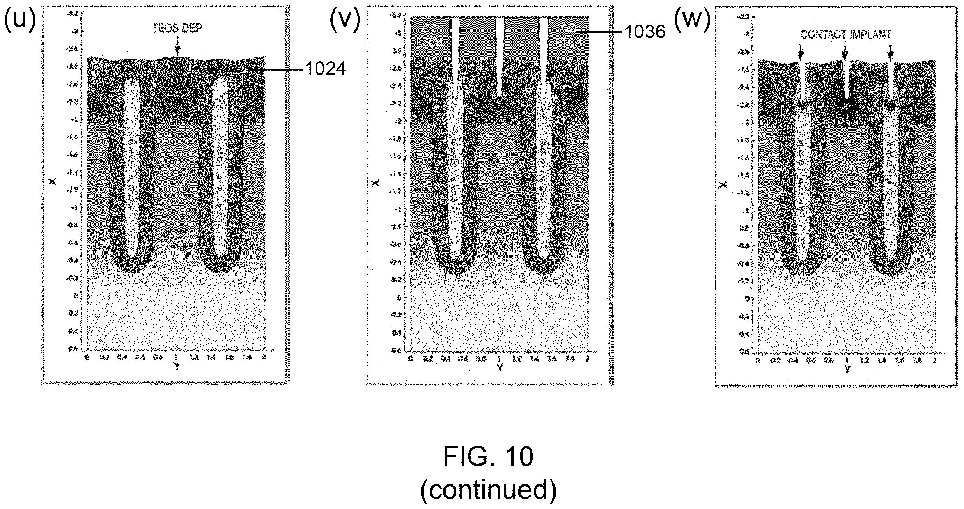

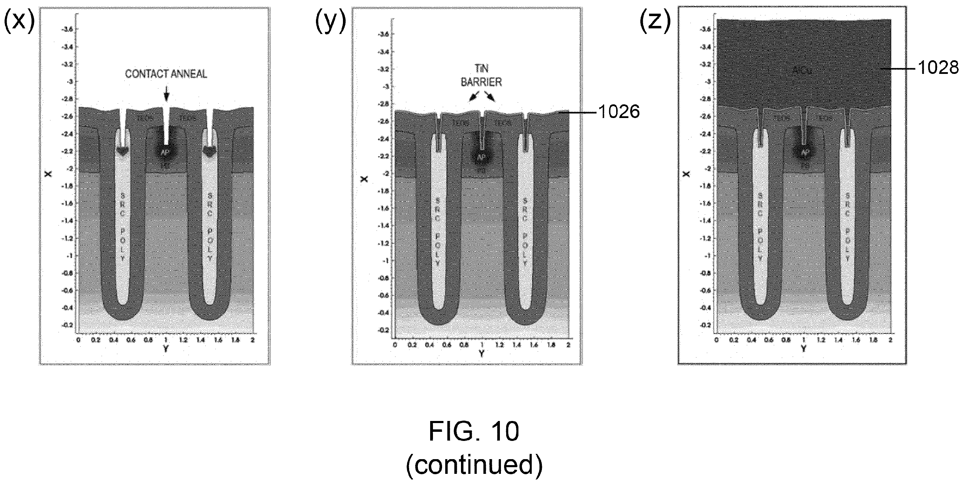

Figure 10 illustrates steps of a method of manufacturing a source terminal within an edge termination region of a MOSFET according to an embodiment of the disclosure, such as that shown in Figure 6. Many of the features are the same as those shown in Figure 6 and therefore carry the same reference numerals. It will be appreciated that the steps shown in Figure 10 may illustrate a subset of all the steps for manufacturing a device, and that the method may further include additional steps preceding or following the steps of Figure 10.

It will also be appreciated that Figures 10(a) to 10(f) represent the same steps as shown in Figures 7(a) to 7(f), and may be performed concurrently using the same processes.

Whilst Figure 10 shows steps in manufacturing an edge termination region 300 having two source trenches, it will be understood that the method may be used to manufacture more than two source trenches.

The steps of the method shown in Figure 10 are performed in order from (a) to (z) as follows:
(a) Two trenches 320 are dry etched in a semiconductor region. In this example, the semiconductor region includes a substrate having epitaxial layers over the substrate. In the example shown, the semiconductor region comprises a silicon region 1002 having a nitride layer 1004 located over the silicon region 1002. The nitride layer may be Si₃N₄ and acts as a hard mask or resist layer to define the trenches during the dry-etch process;
(b) A thin rounding oxide layer 1006 is formed on the inner walls of each trench. The thin rounding oxide layer 1006 is grown and immediately stripped. This cleans up any micro-imperfections on the sidewalls of the trenches that were introduced during the preceding dry etch step shown in Figure 10(a), and rounds any sharp corners of the trenches. In the example shown, the thin rounding oxide layer 1006 has a thickness in range of 100-800Å;
(c) A hardmask strip process is performed to remove the nitride layer from the silicon substrate 1002;
(d) A thin oxide layer is thermally grown on the inner walls and lower surface of each trench and over the upper surface of the mesa region between adjacent trenches. A thicker oxide layer is deposited over the thin oxide layer. The dual-oxide layer 1008 is formed in this two-stage process to control the doping inside the mesa region 325. The thin oxide layer may have a thickness of between 20-500nm, and the thick oxide layer may have a thickness between 80-1000nm to provide an oxide liner 1008 of between 100 to 1500nm thickness. In the example shown, the thin oxide layer may have a thickness of approximately 44nm, and the thick oxide layer may have a thickness of approximately 120nm to provide an oxide liner 1008 of approximately 164nm thick;
(e) Source polysilicon 1010 is deposited within the two trenches and over an upper surface of the device;
(f) The source polysilicon is planarised using chemical mechanical planarization (CMP) to form the source polysilicon 330 of the device of Figure 6;
(g) An inter-polysilicon oxide (IPO) lithography resist mask 1030 is formed over an upper surface of the device. The IPO lithography resist mask 1030 blocks the etching process shown in Figure 7(g) from removing the source polysilicon 330;
(h) A further etching process is performed to etch back the oxide layer in the mesa region and along the sidewalls of the trenches above the source polysilicon, such that the source polysilicon 330 extends slightly above the oxide layer;
(i) Further oxide 1014 is deposited over the surface of the device using high-density-plasma chemical vapour deposition;
(j) A gate definition resist mask 1032 is formed over an upper surface of the device to retain the further oxide 1014 in the edge termination region. The gate definition resist mask 1032 blocks the etching process shown in Figure 7(j) from removing the further oxide 1014;
(k) The source polysilicon 330 is oxidised. The source polysilicon 330 is covered by the further oxide 1014 and will only see minor oxidation, whereas at the same time in the active area the silicon region is oxidised to form the further thin oxide layer 716 as shown in Figure 7(k);
(l) A gate polysilicon layer 1034 is formed over an upper surface of the device;
(m) The gate polysilicon layer is planarised using chemical mechanical planarization (CMP);
(n) An etching step is performed to etch the gate polysilicon region 1034. This may be performed in the same time as the planarization shown in Figures 7(m) and 10(m);
(o) A thick oxide layer 1020 or plug is formed or deposited over an upper surface of the device;
(p) The thick oxide layer 1020 is planarised using chemical mechanical planarization (CMP);
(q) The silicon mesa region located between adjacent gate trenches is etched, to form a recess between the adjacent source trenches. This is performed using the same step as shown in Figure 7(q);
(r) A screen oxide layer 1022 is grown or deposited over an upper surface of the device;
(s) A p-type dopant is implanted into the mesa region, below the screen oxide layer 1020 to form the p-body region 310;
(t) There is no step of implanting n-type dopant in this edge termination region. In some implementations, a further lithography mask (not shown) may be located over the edge termination region and blocks the implantation of an n-type dopant in the edge termination region;
(u) An oxide layer 1024, in this example silicon dioxide (e.g. Tetraethyl orthosilicate (TEOS)), is deposited over an upper surface of the device in a furnace or in a low pressure chemical vapor deposition (LPCVD) tool. Alternatively, a similar insulating layer (e.g. BPSG glass) may be deposited or undoped silicon glass is deposited in a high-density plasma CVD tool;
(v) A mask 1036 defining the location of the source contacts is formed and an etching process is performed to form three recesses extending through the oxide layer. As there are no spacers in the edge termination region, a mask 1036 is used to define and form the contacts. In some embodiments, the contacts formed in the edge termination region as shown in Figures 9 and 10 are manufactured using a stepper as a separate process step, as the functionality of the device is not as affected by the alignment of the contacts in the edge termination region ;
(w) A p-type dopant (for example, Boron) is implanted within each recess to form the source contacts. This is performed using the same step as shown in Figure (x);
(x) The p+ source contacts are annealed after the implantation step shown in Figure 10(x);
(y) A metal barrier layer 1026, such as Titanium or Titanium Nitride (Ti/TiN) is formed over the surface of the device;
(z) A metal contact 1028, in this example an aluminium-copper alloy is formed over the device and extends into the etched recess.

It will be understood that the steps shown in Figure 10 may be performed additionally or concurrently with the steps shown in Figures 7, 8, and 9 to form both the active area and terminals of the edge termination region of a MOSFET device at the same time using the same processes.

The manufacturing process of the edge termination regions, shown in Figures 9 and 10, is compatible with the manufacturing process of the active region shown in Figures 7 and 8. This allows manufacturing of the edge termination structures simultaneously as manufacturing the active area using the method as herein disclosed, to allow electric contacts to be made to the gate electrodes shown in Figure 6, as well as to the source polysilicon electrodes in the trenches and to the surface source electrodes in the mesa region shown in Figure 6. The resultant device is a split-gate RESURF MOSFET.

In the manufacturing processes shown, the contacts to the active cells are self-aligned whilst the contacts to gate and source electrodes are stepper-aligned. Further CMP steps or the etch process shown in Figures 7(v) and/or 7(w) may also remove the TEOS layer 920, 1024 in the edge termination region. In some embodiments, a multi-stage process with lithography steps will be performed: (i) using a first mask to protect the TEOS layer 920, 1024 within the edge termination region and (ii) using a second mask to form the edge termination contacts to gate and source terminals as shown in Figures 9(b) and 10(v).

The skilled person will understand that in the preceding description and appended claims, positional terms such as 'above', 'overlap', 'under', 'lateral, etc. are made with reference to conceptual illustrations of an apparatus, such as those showing standard cross-sectional perspectives and those shown in the appended drawings. These terms are used for ease of reference but are not intended to be of limiting nature. These terms are therefore to be understood as referring to a device when in an orientation as shown in the accompanying drawings.

It will be appreciated that all doping polarities mentioned above could be reversed, the resulting devices still being in accordance with embodiments of the present invention.

In this document, dimensions are provided merely as indicative examples, and are not intended to be limiting.

Although specific embodiments have been described above, the claims are not limited to those embodiments. Those skilled in the art will be able to make modifications and alternatives in view of the disclosure, which are contemplated as falling within the scope of the appended claims.

Each feature disclosed may be incorporated in any of the described embodiments, alone or in an appropriate combination with other features disclosed herein.

### Reference Numerals

- 100: Active region
- 105: n-drift region
- 110: p-body region
- 115: n+ contact region
- 120: Gate trench
- 125: Mesa region
- 130: Source polysilicon
- 135: Insulation layer
- 140: Gate conductive region
- 145: p+ contact region
- 155: Source contact
- 160: Insulating spacers
- 165: Oxide plug region
- 170: Nitride plug region
- 200: Edge termination region
- 205: n-drift region
- 210: p-body region
- 220: Gate trench
- 225: Mesa region
- 230: Source polysilicon
- 235: Insulation layer
- 240: Gate conductive region
- 255: Gate contact
- 260: Insulation layer
- 300: Edge termination region
- 305: n-drift region
- 310: p-body region
- 320: Auxiliary trench
- 325: Mesa region
- 330: Source polysilicon
- 335: Insulation layer
- 345: p+ contact region
- 355: Source contact
- 360: Insulation layer

## Claims

1. A semiconductor power device having an active region, the active region of the device comprising:
a drift region of a first conductivity type;
a body region of a second conductivity disposed over the drift region, wherein the second conductivity type is opposite to the first conductivity type;
at least two split-gate trench regions in contact with the body region and the drift region, wherein two laterally adjacent split-gate trench regions are separated by a mesa region;
two or more contact regions of a first conductivity type located in the mesa region and disposed over the body region, wherein the contact regions of a first conductivity type have a higher doping concentration compared to the doping concentration of the drift region, and wherein the contact regions are in contact with the two adjacent split-gate trench regions so that, in use, a channel is formed along a side of each split-gate trench region and within the body region;
a contact region of a second conductivity type located in the mesa region and disposed over the body region, wherein the contact region of a second conductivity type has a higher doping concentration compared to the doping concentration of the body region, and wherein the contact region of a second conductivity type is in contact with the two or more contact regions of a first conductivity type within the mesa region;
at least two insulating spacer regions located over and aligned with the two or more contact regions of a first conductivity type;
a source contact extending from an upper surface of the device within the mesa region and between the at least two insulating spacer regions, wherein the source contact is in contact with the two or more contact regions of a first conductivity type and the contact region of a second conductivity type.

2. A semiconductor power device according to claim 1, wherein the semiconductor device further includes at least two insulating plug regions located over the split-gate trench regions and adjacent to the dielectric spacer regions.

3. A semiconductor power device according to claim 2, wherein the insulating plug regions are formed of the same material as the insulating spacer regions; and optionally
wherein the insulating plug regions and the insulating spacer regions comprise an oxide.

4. A semiconductor power device according to claim 2, wherein the insulating plug regions are formed of a different material as the insulating spacer regions; and optionally
wherein the insulating plug region comprises a nitride and wherein the insulating spacer regions comprise an oxide.

5. A semiconductor power device according to any of claims 2 to 4, wherein the semiconductor power device is formed by:
forming the at least two split-gate trench regions within a semiconductor region, wherein two laterally adjacent split-gate trench regions are separated by a mesa region;
etching a gate conductive region within an upper region of each split-gate trench region;
forming the at least two insulating plug regions over the etched gate conductive regions, each insulating plug region being formed within a split-gate trench region; and
etching the semiconductor region within the mesa region between two adjacent split-gate trench regions.

6. A semiconductor power device according to any preceding claim, wherein the semiconductor power device is formed by etching a recess within the body region of a second conductivity type in the mesa region, wherein the etched recess is defined by the insulating spacer regions.

7. A semiconductor power device according to claim 6, wherein the contact region of a second conductivity type is formed by implanting a dopant of a second conductivity type into the body region of a second conductivity type below the etched recess; and/or
wherein the source contact is formed by depositing a conductive material in the etched recess.

8. A semiconductor device according to any preceding claim, wherein the split-gate trench regions each comprise:
a gate conductive region formed in an upper portion of each split-gate trench region;
a source conductive region formed in a lower portion of each split-gate trench region; and
an insulation layer formed along sidewalls, a lower surface of each split-gate trench regions and between the gate conductive region and the source conductive region.

9. A semiconductor power device according to any preceding claim, further comprising an edge termination region, wherein the edge termination region is located laterally between the active region and a side surface of the semiconductor device.

10. A semiconductor power device according to claim 9, wherein the edge termination region comprises a gate terminal having one or more split-gate trench regions.

11. A semiconductor power device according to claim 9 or 10, wherein the edge termination region comprises a source terminal having one or more source trench regions.

12. A semiconductor power device according to any preceding claim, wherein the semiconductor device comprises a metal-oxide-semiconductor field-effect transistor (MOSFET).

13. A method of manufacturing an active region of a semiconductor power device, the method comprising:
forming at least two split-gate trench regions within a semiconductor region, wherein two laterally adjacent split-gate trench regions are separated by a mesa region;
etching a gate conductive region within an upper region of each split-gate trench region;
forming at least two insulating plug regions over the etched gate conductive regions, each insulating plug region being formed within a split-gate trench region; and
etching the semiconductor region within the mesa region between two adjacent split-gate trench regions.

14. A method of manufacturing an active region of a semiconductor power device according to claim 13, wherein forming at least two insulating plug regions over the etched gate conductive region within the split-gate trench regions comprises forming an insulating region over an entire surface of the active area and planarising the insulating region to form the insulating plug region.

15. A method of manufacturing an active region of a semiconductor power device according to claim 13 or 14, wherein etching the gate conductive region comprises etching the gate conductive region such that an upper surface of the gate conductive region is substantially below an upper surface of the semiconductor region.

16. A method of manufacturing an active region of a semiconductor power device according to claim 13, 14, or 15, wherein etching the semiconductor region comprises etching the semiconductor region within the mesa region between two adjacent split-gate trench regions such that an upper surface of the mesa region is substantially below an upper surface of the insulating plug regions.

17. A method of manufacturing an active region of a semiconductor power device according to any of claims 13 to 16, further comprising forming at least two insulating spacer regions over the etched mesa region of the semiconductor region and adjacent to the insulating plug regions; and
etching a recess within the mesa region of the semiconductor region, wherein the recess is defined by the insulating spacer regions.

18. A method of manufacturing an active region of a semiconductor power device according to claim 17, wherein forming at least two insulating spacer regions comprises:
forming an insulating layer over the at least two insulating plug regions and the mesa region between the at least two split-gate trench regions; and
etching the insulating layer using an etch process that terminates on an upper surface of the semiconductor region within the mesa region.

19. A method of manufacturing an active region of a semiconductor power device according to claim 17 or 18, wherein the method further comprises:
implanting a dopant of a second conductivity type into the semiconductor substrate below the etched recess; and/or
depositing a conductive material in the etched recess to form a source contact.

20. A method of manufacturing a semiconductor power device comprising:
manufacturing an active region of the semiconductor power device according to any of claims 13 to 19; and
simultaneously manufacturing an edge termination region.

21. A method of manufacturing a semiconductor power device according to claim 20, wherein an edge termination region comprises a gate terminal having one or more split-gate trench regions and/or wherein the edge termination region comprises a source terminal having one or more source trench regions; and
wherein the split-gate trench regions of the gate terminal and/or the source trench regions of the source terminal are formed in a same process as the split-gate trench regions of the active region.
